# EUROPÄISCHE PATENTSCHRIFT

(11) **EP 3 641 087 B1**
(45) Veröffentlichungstag und Bekanntmachung des Hinweises auf die Patenterteilung: **20.07.2022**
(21) Anmeldenummer: 19199097.7
(22) Anmeldetag: 24.09.2019
(51) Int. Cl.: H02H 3/17, G01R 27/18, H02H 11/00, H02H 1/00

(54) **ELEKTRISCHE SCHALTUNGSANORDNUNG UND VERFAHREN ZUR ANKOPPLUNG EINES ISOLATIONSÜBERWACHUNGSGERÄTES AN EIN UNGEERDETES STROMVERSORGUNGSSYSTEM**
ELECTRICAL CIRCUIT ARRANGEMENT AND METHOD FOR COUPLING AN INSULATION MONITORING DEVICE TO AN UNEARTHED POWER SUPPLY SYSTEM
AGENCEMENT DE CIRCUIT ÉLECTRIQUE ET PROCÉDÉ D'ACCOUPLEMENT D'UN APPAREIL DE SURVEILLANCE DE L'ISOLATION À UN SYSTÈME D'ALIMENTATION ÉLECTRIQUE NON MIS À LA TERRE

(30) Priorität: 10.10.2018 DE 102018125004
(43) Veröffentlichungstag der Anmeldung: 22.04.2020
(73) Patentinhaber: Bender GmbH & Co. KG, 35305 Grünberg (DE)
(72) Erfinder: REITZ, Julian, 35305 Grünberg (DE)
(74) Vertreter: advotec.

(56) Entgegenhaltungen:
- EP-A1- 2 664 932
- US-A- 3 823 370

## Beschreibung

Die Erfindung betrifft eine elektrische Schaltungsanordnung und ein Verfahren zur Ankopplung eines Isolationsüberwachungsgerätes an ein ungeerdetes Stromversorgungssystem über eine für jeden aktiven Leiter des Stromversorgungssystems wirksame, als ohmsche Widerstandsschaltung ausgebildete Ankoppelimpedanz.

Der Vorteil eines ungeerdeten Stromversorgungssystems (auch als isoliertes Netz, frz. Isolé Terre - IT-Stromversorgungssystem oder IT-Netz bezeichnet), bei welchem im Gegensatz zu einem geerdeten Stromversorgungssystem sämtliche aktiven Teile des Netzes gegenüber Erde getrennt sind, liegt darin begründet, dass das Netz bei Auftreten eines Isolationsfehlers (erster Fehler) weiter betrieben werden kann, da sich wegen des im Idealfall unendlich großen Impedanzwertes zwischen einem aktiven Leiter des Netzes und Erde kein geschlossener Stromkreis ausbilden kann.

Der Widerstand des ungeerdeten Stromversorgungssystems gegen Erde (Isolationswiderstand - im Fehlerfall auch Isolationsfehlerwiderstand oder Fehlerwiderstand) muss deshalb ständig überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstromschutzeinrichtung eine Abschaltung der Anlage mit Betriebsstillstand zur Folge hätte.

Der Einsatz eines Isolationsüberwachungsgerätes (IMD) nach der Produktnorm IEC 61557-8 zur kontinuierlichen Überwachung des Isolationswiderstands ist daher gesetzmäßig vorgeschrieben.

Die elektrische Verbindung zwischen dem Isolationsüberwachungsgerät und dem zu überwachenden ungeerdeten Stromversorgungssystem wird bei der Inbetriebnahme des IT-Netzes über eine fest vorgegebene, an die Nennspannung des IT-Netzes angepasste und meist in das Isolationsüberwachungsgerät integrierte Ankoppelimpedanz hergestellt.

Einige Isolationsüberwachungsgeräte verfügen zudem über eine Abschaltfunktion, d. h. über eine Trennvorrichtung, welche beim Zusammenschalten einzelner IT-Netze zu einem Gesamtnetz eine Entkopplung bewirken, um gegenseitige Funktionsstörungen mehrerer Isolationsüberwachungsgeräte in gekoppelten Netzen zu verhindern.

Fest vorgegebene, d. h. während des Betriebs in ihrem Widerstandswertunveränderliche, Ankoppelimpedanzen haben den Nachteil, dass eine Messbereichsumschaltung an im Betrieb befindlichen Isolationsüberwachungsgeräten nicht möglich ist.

Ebenso müssen Trennvorrichtungen in nachteiliger Weise ergänzend in Reihe zum Ankoppelpfad in die Schaltung integriert werden und erfordern durch hohe zu überbrückende Spannungsabstände einen zusätzlichen beachtlichen Platzbedarf verbunden mit zusätzlichem finanziellem Aufwand.

Dem Problem, die unterschiedlichen Anforderungen an die Ankoppelimpedanz hinsichtlich der Anpassung an das zu überwachende Stromversorgungssystem zu erfüllen, wurde bislang dadurch begegnet, dass je nach Einsatzgebiet spezielle Gerätevarianten des Isolationsüberwachungsgerätes oder eines separaten Ankoppelgerätes mit Ankoppelimpedanzen installiert werden, deren ohmsche Widerstandsschaltung unterschiedliche, aber unveränderliche (konstante) Widerstandswerteaufweisen.

Die Abschaltfunktion wird dem Stand der Technik gemäß durch eine separate Trennvorrichtung in Form von Optokopplern oder Relais realisiert, die in Reihe zu der Ankoppelimpedanz geschaltet ist.

Weiter ist aus der US-Patentschrift US 3,823,370 A eine Vorrichtung zum Erkennen von Isolationsfehlern auf einem lackisolierten elektrischen Draht bekannt. Dabei wird ein Hochvoltsignal über eine Widerstandsdekade und einen Wählschalter mittels eines Spurrades, welches an dem zu prüfenden Draht entlangfährt, auf den Draht gegeben. Über einen Widerstandsstromsensor werden an Fehlerstellen auftretende Spannungsimpulse erfasst und ausgewertet.

Die Offenlegungsschrift EP 2 664 932 A1 beschreibt in einer komplexen Schaltungsanordnung die Erzeugung von Pulssignalen für die Isolationsfehlersuche in ungeerdeten Stromversorgungssystemen. Eine Stromregelungseinrichtung der Pulsgenerator-Schaltungsanordnung ermöglicht über einen variablen Innenwiderstand als Stellglied eine dynamische Einstellung des Pulsstroms in Abhängigkeit des ermittelten Isolationswiderstands.

Der vorliegenden Erfindung liegt somit die Aufgabe zugrunde, eine elektrische Schaltungsanordnung und ein Verfahren zur Ankopplung eines Isolationsüberwachungsgerätes an ein ungeerdetes Stromversorgungssystem vorzuschlagen, die hinsichtlich der Messgenauigkeit und elektrischen Anpassung sowie im Hinblick auf eine Abschaltfunktion eine schaltungstechnisch einfache, flexible und kostengünstige Realisierung ermöglichen.

Diese Aufgabe wird in Verbindung mit den Merkmalen des Oberbegriffs des Anspruchs 1 dadurch gelöst, dass die ohmsche Widerstandsschaltung mit einem einstellbar veränderlichen Widerstandswert und mit einer Abschaltfunktion zur Netzabkopplung des Isolationsüberwachungsgerätes ausgeführt ist.

Der Grundgedanke der vorliegenden Erfindung beruht in vorteilhafter Weise darauf, den Nachteil der fehlenden Einstellbarkeit und der begrenzten Flexibilität der aus dem Stand der Technik bekannten Ankoppelimpedanzen, verbunden mit dem Aufwand zusätzlicher Schalter, dadurch zu beheben, dass anstelle der separaten Trennvorrichtung und der fest vorgegebenen Ankoppelimpedanz diese Ankoppelimpedanz als ohmsche Widerstandsschaltung ausgeführt wird, die einen einstellbar veränderlichen Widerstandswert aufweist und zugleich eine Abschaltfunktion zur Netzabkopplung des Isolationsüberwachungsgerätes bewirkt.

Dadurch wird während des Betriebs des Isolationsüberwachungsgerätes bei einer Veränderung der Netzeigenschaften, wie beispielsweise einer 2. Isolationsverschlechterung, die Möglichkeit einer Erhöhung der Messge-nauigkeit geschaffen, da sich das Isolationsüberwachungsgerät aufgrund der ohmschen Widerstandsschaltung mit einem einstellbar veränderlichen Widerstandswert durch entsprechende Mess- und Steueralgorithmen eigenständig an die Messumgebung anpassen kann.

Die mit dem einstellbar veränderlichen Widerstandswert kombinierte Abschaltfunktion verwirklicht eine integrierte Trennvorrichtung ohne den Aufwand von separaten Schaltern in Form von Optokopplern oder Relais, welche in Reihe zu einer nach dem Stand der Technik bekannten Ankoppelimpedanz geschaltet werden müssten.

In weiterer vorteilhafter Ausgestaltung ist die ohmsche Widerstandsschaltung als bidirektionale Kaskade, bestehend aus einer Reihenschaltung von zwei spiegelbildlich angeordneten Transistoren mit jeweils einer parallel geschalteten Diode, ausgebildet, wobei zur Einstellung des veränderlichen Widerstandswertes eine gesteuerte Widerstandsänderung der Transistoren durch einen Regelkreis erfolgt und die Abschaltfunktion zur Netzabkopplung durch Einstellen eines maximalen Widerstandswerts realisiert wird.

Diese bidirektionale Struktur kann sowohl in einem Wechselstrom-Stromversorgungssystem als auch in einem Gleichstrom-Stromversorgungssystem verwendet werden und bildet durch eine geregelte Arbeitspunktverschiebung im Kennlinienfeld der Transistoren die Funktion einer ohmschen Widerstandsschaltung mit einem in den Grenzen zwischen einem minimalen Widerstand und einem maximalen Widerstand veränderlichen Widerstandswert.

Die Abschaltfunktion wird dadurch geschaffen, dass die Transistoren vollständig zu dem maximalen Widerstandswert (R_{∞}) angesteuert werden und lediglich ein vernachlässigbarer Sperrstrom fließt.

Die Ansteuerung der Transistoren erfolgt dabei mittels eines Regelkreises, über den ein vorgebbarer Soll-Widerstandswert angegeben wird. Der Regelkreis ist dabei ein funktionaler Bestandteil der erfindungsgemäßen Schaltungsanordnung. Strukturell (gegenständlich) können Teile des Regelkreises, wie zum Beispiel der Regler, auf einem Mikroprozessor in dem Isolationsüberwachungsgerät implementiert sein.

Mit Vorteil weist der Regelkreis auf: einen Transformationsblock, welcher mittels eines Ist-Stroms einen vorgebbaren Soll-Widerstandswert in eine Soll-Spannung als Führungsgröße transformiert; eine Strommessung, welche einen durch die Transistor-Kaskade fließenden Transistor-Strom erfasst und skaliert als Ist-Strom in den Transformationsblock zurückführt; ein Vergleichsglied, welches die Soll-Spannung mit einer Ist-Spannung vergleicht und eine Differenzspannung als Regelabweichung bildet; eine Spannungsmessung, welche eine über der Transistor-Kaskade abfallende Transistor-Spannung erfasst und skaliert als Ist-Spannung in das Vergleichsglied zurückführt; einen Regler, der aus der Differenzspannung eine Stellgröße zur Ansteuerung einer Regelstrecke erzeugt, die durch die bidirektionale Transistor-Kaskade mit dem veränderlichen Widerstandswert als Regelgröße gebildet ist.

Die als bidirektionale Transistor-Kaskade gebildete ohmsche Widerstandsschaltung mit dem veränderlichen Widerstandswert als Regelgröße bildet die Regelstrecke des Regelkreises. Innerhalb der Regelstrecke ist der bidirektionalen Transistor-Kaskade eine Transistor-Treiberschaltung vorgeschaltet, die durch eine von einem Regler bereitgestellte Stellgröße angesteuert wird. Der Regler wiederum erzeugt diese Stellgröße aus einer Differenzspannung, die in einem Vergleichsglied erzeugt wird. Diese Differenzspannung stellt die Regelabweichung zwischen einer Soll-Spannung und einer Ist-Spannung dar, wobei eine Spannungsmessung die über der Transistor-Kaskade abfallende Transistor-Spannung erfasst und skaliert als Ist-Spannung in das Vergleichsglied zurückführt und die Soll-Spannung als Führungsgröße aus einem vorgebbaren Soll-Widerstandswert mittels eines Ist-Stroms in einem Transformationsblock abgeleitet wird.

Durch eine Strommessung wird der durch die Transistor-Kaskade fließende Transistor-Strom ermittelt und skaliert als Ist-Strom dem Transformationsblock zugeführt.

Zur Einstellung eines gewünschten Widerstandswertes wird der Schaltungsanordnung lediglich ein Soll-Wert des Widerstandswertes vorgegeben. Der gewünschte Widerstandswert stellt sich mittels der in dem Regelkreis ausgeführten Strommessung des in der Transistor-Kaskade fließenden Transistor-Stroms und der in dem Regelkreis ausgeführten Spannungsmessung der über der Transistor-Kaskade abfallenden Transistor-Spannung selbstständig ein.

Zusätzlich weist die Regelung den Vorteil auf, dass aus der Umgebung auf die Transistoren einwirkende Störeinflüsse, wie beispielsweise Temperaturänderungen, ausgeglichen werden.

Bevorzugt ist der Regler als PI-Regler ausgeführt.

Als Regler gelangt in dem Regelkreis vorzugsweise ein PI-Regler zur Anwendung, der neben seinem proportionalen Verhalten (P-Anteil) einen überlagerten Integralanteil aufweist und damit zu keiner bleibenden Regelabweichung führt.

Mit Vorteil ist ein Schutzwiderstand für jeden aktiven Leiter in Reihe zu der jeweiligen ohmschen Widerstandsschaltung geschaltet.

Für den Fehlerfall einer kurzgeschlossenen Transistor-Kaskade sind Schutzwiderstände vorgesehen.

In weiterer Ausgestaltung ist die elektrische Schaltungsanordnung als Erweiterungsmodul für das Isolationsüberwachungsgerät oder als separate bauliche Einheit ausgeführt.

Die erfindungsgemäße Schaltungsanordnung kann als integraler Bestandteil eines Isolationsüberwachungsgerätes ausgeführt sein, welches somit eine Anpassung des Nennspannung-Arbeitsbereiches an die Nennspannung des zu überwachenden Stromversorgungssystems ermöglicht und zugleich die Funktion einer Trennvorrichtung aufweist.

Alternativ kann die erfindungsgemäße Schaltungsanordnung auch als separate bauliche Einheit ausgeführt sein, die als Ankoppelgerät zwischen das zu überwachende Stromversorgungssystem und das Isolationsüberwachungsgerät geschaltet wird.

Die der Erfindung zugrunde liegende Aufgabe wird weiterhin gelöst durch ein Verfahren zur Ankopplung eines Isolationsüberwachungsgerätes an ein ungeerdetes Stromversorgungssystem über eine für jeden aktiven Leiter des Stromversorgungssystems wirksame, als ohmsche Widerstandsschaltung ausgebildete Ankoppelimpedanz, wobei ein Einstellen eines veränderlichen Widerstandswertes der ohmschen Widerstandsschaltung erfolgt und durch das Einstellen des Widerstandswertes eine Abschaltfunktion zur Netzabkopplung des Isolationsüberwachungsgerätes bewirkt werden kann.

Die zuvor beschriebene erfindungsgemäße elektrische Schaltungsanordnung beruht auf einem Verfahren zur Ankopplung eines Isolationsüberwachungsgerätes an ein ungeerdetes Stromversorgungssystem über eine ohmsche Widerstandsschaltung mit veränderlichem Widerstandswert und einer Abschaltfunktion zur Netzabkopplung des Isolationsüberwachungsgerätes. Insoweit treffen auch die vorgenannten technischen Wirkungen und daraus resultierenden Vorteile auf die Verfahrensmerkmale zu.

Insbesondere kann durch das erfindungsgemäße Verfahren mittels des stufenlos veränderlichen Widerstandswertes der als ohmsche Widerstandsschaltung ausführten Ankoppelimpedanz das Isolationsüberwachungsgerät an die jeweils aktuellen Netzbedingungen angepasst werden und dadurch sowohl die Einschwingzeiten bei der Isolationswiderstandsmessung verkürzt als auch die Messgenauigkeiten erhöht werden, ohne die Hardware des Isolationsüberwachungsgerätes verändern zu müssen. Für die Ankopplung eines Isolationsüberwachungsgeräts an ein zu überwachendes ungeerdetes Stromversorgungssystem wird mit der vorliegenden Erfindung eine stufenlos einstellbare Ankoppelimpedanz auf der Basis von Leistungshalbleitern geschaffen, die zugleich mit der Möglichkeit einer Abschaltfunktion (Netztrennung) kombiniert wird.

Der Regelkreis ermöglicht die Minimierung von Abweichungen zwischen Ist- und Soll-Widerstandswerten unter Berücksichtigung von Störeinflüssen.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern. Es zeigen:
- **Fig. 1**: eine Isolationsüberwachung nach dem Stand der Technik,
- **Fig. 2**: eine erfindungsgemäße elektrische Schaltungsanordnung mit Ankoppelimpedanz mit einem einstellbar veränderli-chen Widerstandswert und
- **Fig. 3**: einen Regelkreis der erfindungsgemäßen elektrischen Schaltungsanordnung.

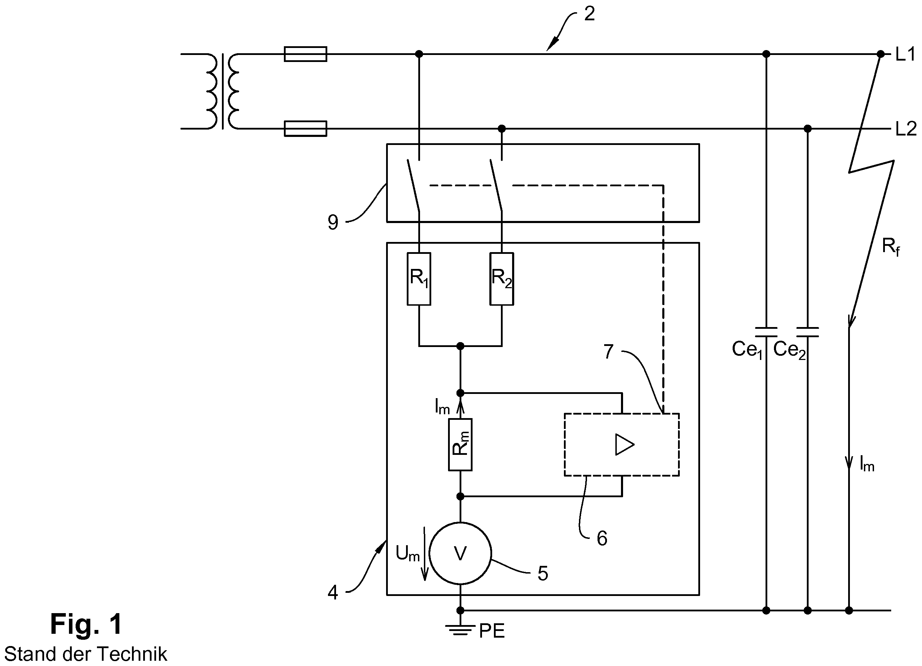

Die **Fig. 1** zeigt ein ungeerdetes Stromversorgungssystem 2 mit aktiven Leitern L₁ und L₂, an das zwischen die aktiven Leiter L₁, L₂ und Erde PE ein Isolationsüberwachungsgerät 4 in Reihe mit einer Trennvorrichtung 9 geschaltet ist. Das ungeerdete Stromversorgungssystem 2 ist weiterhin charakterisiert durch die Ableitkapazitäten Ce₁, Ce₂ gegenüber Erde PE sowie einen von dem Isolationsüberwachungsgerät 4 zu überwachenden Isolationswiderstand R_{f} gegen Erde PE.

Das Isolationsüberwachungsgerät 4 umfasst einen Messspannungsgenerator 5, der eine Messspannung Uₘ erzeugt und dem ungeerdeten Stromversorgungssystem 2 überlagert. Der Messkreis schließt sich über den Isolationswiderstand R_{f} und führt zu einem Messstrom Iₘ, der an einem Messwiderstand Rₘ einen Spannungsabfall bewirkt, aus dem in einer Auswerteeinrichtung 6 der Wert des Isolationswiderstands R_{f} bestimmt werden kann.

Die Auswerteeinrichtung 6 weist zur Ansteuerung der Trennvorrichtung 9 zusätzlich einen Signalausgang 7 auf, über den die Isolationsüberwachung deaktiviert werden kann.

In dem Isolationsüberwachungsgerät 4 sind weiterhin als Ankoppelimpedanz die Widerstände R₁ und R₂ mit fest vorgegebenen Widerstandswerten vorgesehen, um den Arbeitsbereich des Isolationsüberwachungsgerätes 4 an eine Netznennspannung des ungeerdeten Stromversorgungssystems 2 anzupassen.

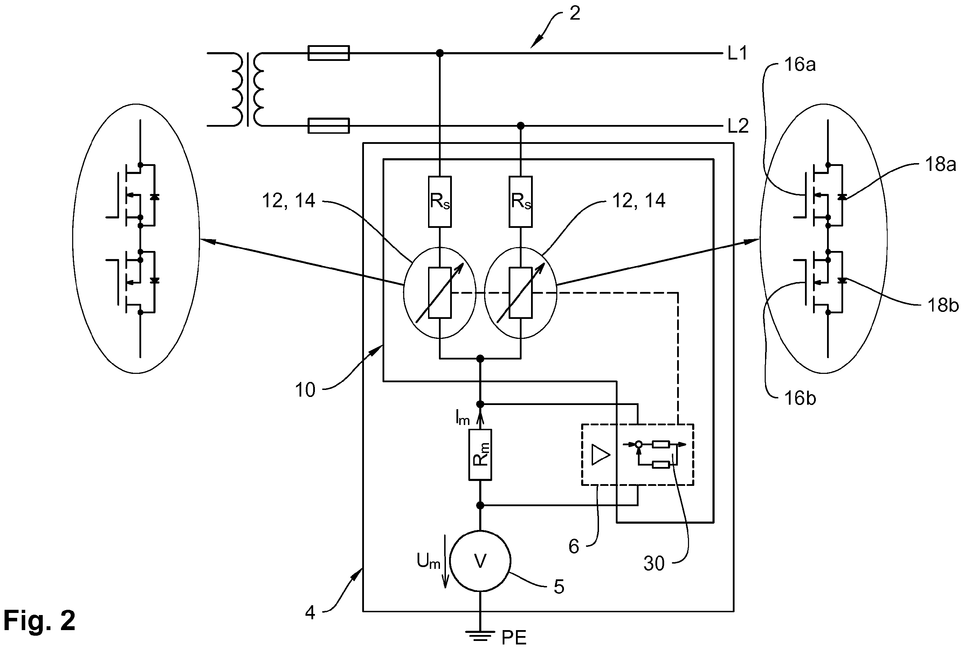

In **Fig. 2** ist eine erfindungsgemäße elektrische Schaltungsanordnung 10 mit der Ankoppelimpedanz als ohmsche Widerstandsschaltung 12 mit einem einstellbar veränderlichen Widerstandswert dargestellt.

In Abänderung der in Fig. 1 gezeigten und aus dem Stand der Technik bekannten, fest vorgegebenen Ankoppelwiderstände R₁ und R₂ weist die erfindungsgemäße elektrische Schaltungsanordnung 10 zur Ankopplung des Isolationsüberwachungsgerätes 4 als Ankoppelimpedanz für jeden aktiven Leiter L₁, L₂ eine ohmsche Widerstandsschaltung 12 auf, welche als bidirektionale Transistor-Kaskade 14 ausgeführt ist.

Die bidirektionale Transistor-Kaskade 14 besteht aus einer Reihenschaltung von zwei spiegelbildlich angeordneten Transistoren 16a, 16b mit jeweils einer parallel geschalteten Diode 18a, 18b. Als Transistoren 16a, 16b werden vorzugsweise MOSFETs verwendet, wobei über eine MOSFET-Treiberschaltung eine geregelte Arbeitspunktverschiebung im Kennlinienfeld der Transistoren 16a, 16b erfolgt, sodass sich spannungsgesteuert der gewünschte Widerstandswert einstellt.

Als Schutzbeschaltung für den Fall einer kurzgeschlossenen Transistor-Kaskade 14 sind Schutzwiderstände Rₛ zur Strombegrenzung vorgesehen.

Die Ansteuerung der Transistor-Kaskade 14 erfolgt über einen Regelkreis 30, der vorliegend in die Auswerteeinrichtung 6 des Isolationsüberwachungsgerätes 4 integriert ist. Die erfindungsgemäße elektrische Schaltungsanordnung 10 zur Ankopplung des Isolationsüberwachungsgerätes 4 ist in der dargestellten Ausführung als Erweiterungsmodul des Isolationsüberwachungsgerätes 4 ausgeführt. Möglich ist aber auch eine Ausführung als separate bauliche Einheit.

In beiden Ausführungsformen stellt die erfindungsgemäße elektrische Schaltungsanordnung 10 aufgrund des einstellbar veränderlichen Widerstandswertes mit integrierter Abschaltfunktion auf der Basis von Halbleiter-Bauelementen eine schaltungstechnisch einfache und kostengünstige Realisierung einer Ankopplung für ein Isolationsüberwachungsgerät 4 dar.

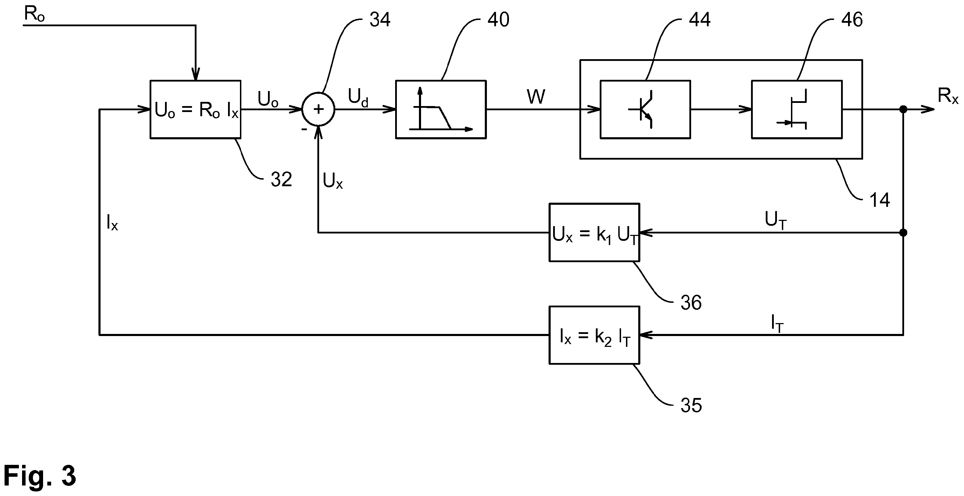

**Fig. 3** zeigt einen Regelkreis 30 der erfindungsgemäßen Schaltungsanordnung zur Ankopplung des Isolationsüberwachungsgerätes 4. Als Eingangsgröße des Regelkreises wird zunächst der gewünschte Widerstandswert R₀ angegeben, welcher über einen Transformationsblock 32 in eine Soll-Spannung U₀ transformiert wird. Die Transformation erfolgt mittels einer Strommessung 35, die den Transistor-Strom I_{T} über der Transistor-Kaskade 14 erfasst und skaliert als Ist-Strom Iₓ dem Transformationsblock 32 zuführt.

In einem Vergleichsglied 34 wird aus der Soll-Spannung U₀ und einer Ist-Spannung Uₓ, welche über eine Spannungsmessung 36 aus der über der Transistor-Kaskade 14 abfallenden Transistor-Spannung U_{T} gewonnen wird, eine Differenzspannung U_{d} gebildet. Die Differenzspannung U_{d} wird einem Regler 40, der vorzugsweise ein PI-Regler ist, zugeführt, der daraus eine Stellgröße W zur Ansteuerung der Transistor-Kaskade 14 bildet.

Die Transistor-Kaskade 14 umfasst neben der eigentlichen Transistor(reihen)schaltung 46 eine Treiberschaltung 44 zur Ansteuerung der Transistorschaltung 46. Als Regelgröße nähert sich der Ist-Widerstandswert Rₓ der Transistor-Kaskade 14 dem vorgebbaren Soll-Widerstandswert R₀ an.

## Patentansprüche

1. Elektrische Schaltungsanordnung (10) zur Ankopplung eines Isolationsüberwachungsgerätes (4) an ein ungeerdetes Stromversorgungssystem (2), mit einer für jeden aktiven Leiter des Stromversorgungssystems (2) wirksamen, als ohmsche Widerstandsschaltung (12) ausgebildete Ankoppelimpedanz,
**dadurch gekennzeichnet, dass**
die ohmsche Widerstandsschaltung (12) mit einem einstellbar veränderlichen Widerstandswert und mit einer Abschaltfunktion zur Netzabkopplung des Isolationsüberwachungsgerätes (4) ausgeführt ist, wobei die ohmsche Widerstandsschaltung (12) als bidirektionale Kaskade (14), bestehend aus einer Reihenschaltung von zwei spiegelbildlich angeordneten Transistoren (16a, 16b) mit jeweils einer parallel geschalteten Diode (18a, 18b), ausgebildet ist, wobei zur Einstellung des veränderlichen Widerstandswertes eine gesteuerte Widerstandsänderung der Transistoren (16a, 16b) durch einen Regelkreis (30) erfolgt und die Abschaltfunktion zur Netzabkopplung durch Einstellen eines maximalen Widerstandswertes realisiert wird.

2. Elektrische Schaltungsanordnung (10) nach Anspruch 1,
**dadurch gekennzeichnet,**
**dass** der Regelkreis (30) aufweist:
einen Transformationsblock (32), welcher mittels eines Ist-Stroms (Iₓ) einen vorgebbaren Soll-Widerstandswert (R₀) in eine Soll-Spannung (U₀) als Führungsgröße transformiert;
eine Strommessung (35), welche einen durch die Transistor-Kaskade (14) fließenden Transistor-Strom (I_{T}) erfasst und skaliert als Ist-Strom (Iₓ) in den Transformationsblock (32) zurückführt;
ein Vergleichsglied (34), welches die Soll-Spannung (U₀) mit einer Ist-Spannung (Uₓ) vergleicht und eine Differenzspannung (U_{d}) als Regelabweichung bildet;
eine Spannungsmessung (36), welche eine über der Transistor-Kaskade (14) abfallende Transistor-Spannung (U_{T}) erfasst und skaliert als Ist-Spannung (Uₓ) in das Vergleichsglied (34) zurückführt;
einen Regler (40), der aus der Differenzspannung (U_{d})eine Stellgröße (W) zur Ansteuerung einer Regelstrecke erzeugt, die durch die bidirektionale Transistor-Kaskade (14) mit dem veränderlichen Widerstandswert als Regelgröße gebildet ist.

3. Elektrische Schaltungsanordnung (10) nach Anspruch 2,
**dadurch gekennzeichnet, dass**
der Regler (40) als PI-Regler ausgeführt ist.

4. Elektrische Schaltungsanordnung (10) nach einem der Ansprüche 1 bis 3,
**gekennzeichnet durch**
einen Schutzwiderstand (Rs) für jeden aktiven Leiter (L₁, L₂), welcher in Reihe zu der jeweiligen ohmschen Widerstandsschaltung (12) geschaltet ist.

5. Elektrische Schaltungsanordnung (10) nach einem der Ansprüche 1 bis 4,
**gekennzeichnet durch**
eine Ausführung als Erweiterungsmodul für das Isolationsüberwachungsgerät (4) oder als separate bauliche Einheit.

6. Verfahren zur Ankopplung eines Isolationsüberwachungsgerätes (4) an ein ungeerdetes Stromversorgungssystem (2) über eine für jeden aktiven Leiter des Stromversorgungssystems (2) wirksame, als ohmsche Widerstandsschaltung (12) ausgebildete Ankoppelimpedanz, **gekennzeichnet durch**
Einstellen eines veränderlichen Widerstandswertes der ohmschen Widerstandsschaltung (12), wobei durch das Einstellen des Widerstandswertes eine Abschaltfunktion zur Netzabkopplung des Isolationsüberwachungsgerätes bewirkt werden kann, wobei für die ohmsche Widerstandsschaltung (12), die als bidirektionale Kaskade (14), bestehend aus einer Reihenschaltung von zwei spiegelbildlich angeordneten Transistoren (16a, 16b) mit jeweils einer parallel geschalteten Diode (18a, 18b), ausgebildet ist, das Einstellen des veränderlichen Widerstandswertes durch eine gesteuerte Widerstandsänderung der Transistoren (16a, 16b) innerhalb eines Regelkreises (30) erfolgt und die Netzabkopplung durch Einstellen eines maximalen Widerstandswertes realisiert wird.

7. Verfahren nach Anspruch 6,
**dadurch gekennzeichnet, dass**
in dem Regelkreis (30)
durch einen Transformationsblock (32) mittels eines Ist-Stroms (Iₓ) ein vorgebbarer Soll-Widerstandswert (R₀) in eine Soll-Spannung (U₀) als Führungsgröße transformiert wird;
mit einer Strommessung (35) ein durch die Transistor-Kaskade (14) fließender Transistor-Strom (I_{T}) erfasst und skaliert als Ist-Strom (Iₓ) in den Transformationsblock (32) zurückführt wird;
in einem Vergleichsglied die Soll-Spannung (U₀) mit einer Ist-Spannung (Uₓ) verglichen wird und eine Differenzspannung (U_{d}) als Regelabweichung gebildet wird;
mit einer Spannungsmessung (36) eine über der Transistor-Kaskade (14) abfallende Transistor-Spannung (U_{T}) erfasst und skaliert als Ist-Spannung (Uₓ) in das Vergleichsglied (34) zurückgeführt wird; in einem Regler aus der Differenzspannung (U_{d}) eine Stellgröße erzeugt wird, welche
eine Regelstrecke ansteuert, die aus der bidirektionalen Transistor-Kaskade (14) mit dem veränderlichen Widerstandswert als Regelgröße gebildet ist.

8. Verfahren nach Anspruch 7,
**dadurch gekennzeichnet,**
**dass** als Regler (40) ein PI-Regler implementiert wird.

9. Verfahren nach einem der Ansprüche 6 bis 8,
**dadurch gekennzeichnet,**
**dass** ein Schutzwiderstand (Rs) für jeden aktiven Leiter (L₁, L₂) in Reihe zu der jeweiligen ohmschen Widerstandsschaltung (12) geschaltet wird.

## Claims

1. An electric circuit arrangement (10) for coupling an insulation monitoring device (4) to an ungrounded power supply system (2), the electric circuit arrangement (10) having a coupling impedance which is realized to be operant for each active conductor of the power supply system (2) and which is formed as an ohmic resistance circuit (12),
**characterized in that**
the ohmic resistance circuit (12) is designed to have a settable resistance value which is changeable and to have a switching-off function for decoupling the insulation monitoring device (4) from the network, the ohmic resistance circuit (12) being realized as a bidirectional cascade (14) which consists of a series circuit of two transistors (16a, 16b) provided in a mirror-inverted manner, each having a diode (18a, 18b) connected in parallel, wherein a controlled change in resistance of the transistors (16a, 16b) for setting the changeable resistance value is effected by a control circuit (30) and the switching-off function for decoupling from the network is realized by setting a maximum resistance value.

2. The electric circuit arrangement (10) according to claim 1, **characterized in that**
the control circuit (30) comprises:
a transformation block (32) which transforms a settable target resistance value (R₀) to a target voltage (U₀) as a reference variable by means of an actual current (Iₓ);
a current measurement (35) which measures a transistor current (I_{T}) flowing through the transistor cascade (14) and which supplies said transistor current (I_{T}), scaled as an actual current (Iₓ), back into the transformation block (32);
a comparison element (34) which compares the target voltage (U₀) to an actual voltage (Uₓ) and forms a differential voltage (U_{d}) as a control deviation;
a voltage measurement (36) which measures a transistor voltage (U_{T}) dropping across the transistor cascade (14) and which supplies said transistor voltage (U_{T}), scaled as an actual voltage (Uₓ), back into the comparison element (34);
a controller (40) which generates a manipulated variable (W) from the differential voltage (U_{d}) for controlling a controlled system, said manipulated variable (W) being formed by means of the bidirectional transistor cascade (14) having the changeable resistance value as a controlled variable.

3. The electric circuit arrangement (10) according to claim 2, **characterized in that**
the controller (40) is designed as a PI controller.

4. The electric circuit arrangement (10) according to any one of the claims 1 to 3,
**characterized by**
a protective resistor (Rs) for each active conductor (L₁, L₂), which is connected in series to the respective ohmic resistance circuit (12).

5. The electric circuit arrangement (10) according to any one of the claims 1 to 4,
**characterized by**
an embodiment as an extension module for the insulation monitoring device (4) or as a separate structural unit.

6. A method for coupling an insulation monitoring device (4) to an ungrounded power supply system (2) via a coupling impedance, which is realized to be operant for each active conductor of the power supply system (2) and which is formed as an ohmic resistance circuit (12),
**characterized by**
setting a changeable resistance value of the ohmic resistance circuit (12), wherein a switching-off function for decoupling the insulation monitoring device from the network can be caused by setting the resistance value, wherein for the ohmic resistance circuit (12), which is realized as a bidirectional cascade (14) consisting of a series circuit of two transistors (16a, 16b) provided in a mirror-inverted manner, each having a diode (18a, 18b) connected in parallel, the setting of the changeable resistance value is effected by means of a controlled change in resistance of the transistors (16a, 16b) within a control circuit (30) and the switching-off function for decoupling from the network is realized by setting a maximum resistance value.

7. The method according to claim 6,
**characterized in that**
in the control circuit (30),
a settable target resistance value (R₀) is transformed to a target voltage (U₀) as a reference variable through a transformation block (32) by means of an actual current (Iₓ);
a transistor current (I_{T}) flowing through the transistor cascade (14) is measured and supplied to the transformation block (32) scaled as an actual current (Iₓ) by means of a current measurement (35);
the target voltage (U₀) is compared to an actual voltage (Uₓ) in a comparison element (34) and a differential voltage (U_{d}) is formed as a control deviation;
a transistor voltage (U_{T}) dropping across the transistor cascade (14) is measured and supplied to the comparison element (34) scaled as an actual voltage (Uₓ) by means of a voltage measurement (36);
a manipulated variable is generated from the differential voltage (U_{d}) in a controller, said manipulated variable
controlling a controlled system, which is formed from the bidirectional transistor cascade (14) having the changeable resistance value as a controlled variable.

8. The method according to claim 7,
**characterized in that**
a PI controller is implemented as the controller (40).

9. The method according to any one of the claims 6 to 8,
**characterized in that**
a protective resistor (Rs) for each active conductor (L₁, L₂) is connected in series to the respective ohmic resistance circuit (12).

## Revendications

1. Arrangement de circuit (10) électrique pour coupler un contrôleur (4) permanent d'isolement à un système d'alimentation (2) non mis à la terre, l'arrangement de circuit (10) électrique ayant une impédance de couplage qui est effective pour chaque conducteur actif du système d'alimentation (2) et qui est réalisée comme circuit de résistance (12) ohmique,
**caractérisé en ce que**
le circuit de résistance (12) ohmique est conçu de façon à avoir une valeur de résistance qui peut être changée de manière ajustable et de façon à avoir une fonction de déclenchement pour le découplage du contrôleur (4) permanent d'isolement du réseau électrique, le circuit de résistance (12) ohmique étant réalisé comme cascade (14) bidirectionnelle qui consiste en un montage en série de deux transistors (16a, 16b) disposés en miroir, chaque transistor ayant une diode (18a, 18b) montée en parallèle, dans lequel, pour ajuster la valeur de résistance changeable, un changement régulé dans la résistance des transistors (16a, 16b) est effectué par un circuit de réglage (30) et la fonction de déclenchement pour le découplage du réseau électrique étant effectuée par l'ajustement d'une valeur de résistance maximal

2. Arrangement de circuit (10) électrique selon la revendication 1, **caractérisé en ce que**
le circuit de réglage (30) comprend :
un bloc de transformation (32) qui transforme une valeur de résistance (R₀) cible pouvant être déterminée d'avance en une tension (U₀) cible comme variable de référence au moyen d'un courant (Iₓ) effectif ;
une mesure de courant (35) qui mesure un courant de transistor (I_{T}) traversant la cascade de transistors (14) et qui ramène ledit courant de transistor (I_{T}) dans le bloc de transformation (32) de manière mise à l'échelle comme courant (Iₓ) effectif ;
un élément de comparaison (34) qui compare la tension (U₀) cible à une tension (Uₓ) effective et qui forme une tension (U_{d}) différentielle comme écart de réglage ;
une mesure de tension (36) qui mesure une tension de transistor (U_{T}) chutant à travers la cascade de transistors (14) et qui ramène ladite tension de transistor (U_{T}) dans l'élément de comparaison (34) de manière mise à l'échelle comme tension (Uₓ) effective ;
un régulateur (40) qui génère une variable réglante (W) à partir de la tension (U_{d}) différentielle pour commander une système commandé,
la variable réglante (W) étant formée au moyen de la cascade de transistors (14) bidirectionnelle ayant la valeur de résistance changeable comme variable commandée.

3. Arrangement de circuit (10) électrique selon la revendication 2, **caractérisé en ce que**
le régulateur (40) est conçu comme régulateur PI.

4. Arrangement de circuit (10) électrique selon l'une quelconque des revendications 1 à 3,
**caractérisé par**
une résistance de protection (Rs) pour chaque conducteur actif (L₁, L₂) qui est montée en série au circuit de résistance (12) ohmique respectif.

5. Arrangement de circuit (10) électrique selon l'une quelconque des revendications 1 à 4,
**caractérisé par**
une variante comme module d'extension pour le contrôleur (4) permanent d'isolement ou comme unité structurelle séparée.

6. Procédé pour le couplage d'un contrôleur (4) permanent d'isolement à un système d'alimentation (2) non mis à la terre par une impédance de couplage qui est effective pour chaque conducteur actif du système d'alimentation (2) et qui est réalisée comme circuit de résistance (12) ohmique,
**caractérisé par**
l'ajustage d'une valeur de résistance changeable du circuit de résistance (12) ohmique, une fonction de déclenchement pour le découplage du contrôleur permanent d'isolement du réseau électrique pouvant être effectuée par l'ajustage de la valeur de résistance, dans lequel, pour le circuit de résistance (12) ohmique, qui est réalisé comme cascade (14) bidirectionnelle consistant en un montage en série de deux transistors (16a, 16b) disposés en miroir, chaque transistor ayant une diode (18a, 18b) montée en parallèle, l'ajustage de la valeur de résistance changeable est effectué au moyen d'un changement régulé dans résistance des transistors (16a, 16b) dans un circuit de réglage (30) et le découplage du réseau électrique est réalisé par l'ajustage d'une valeur de résistance maximal.

7. Procédé selon la revendication 6,
**caractérisé en ce que**
dans le circuit de réglage (30),
une valeur de résistance (R₀) cible pouvant être déterminée d'avance est transformée en une tension (U₀) cible comme variable de référence par un bloc de transformation (32) au moyen d'un courant (Iₓ) effectif ;
un courant de transistor (I_{T}) traversant la cascade de transistors (14) est mesuré et est ramené dans le bloc de transformation (32) de manière mise à l'échelle comme courant (Iₓ) effectif par une mesure de courant (35) ;
la tension (U₀) cible est comparée à une tension (Uₓ) effective et une tension (U_{d}) différentielle est formée comme écart de réglage dans un élément de comparaison (34) ;
une tension de transistor (U_{T}) chutant à travers la cascade de transistors (14) est mesurée et est ramenée dans l'élément de comparaison (34) de manière mise à l'échelle comme tension (Uₓ) effective par une mesure de tension (36) ;
une variable réglante est générée à partir de la tension (U_{d}) différentielle dans un régulateur (40), ladite variable réglante commandant une système commandé et étant formée de la cascade de transistors (14) bidirectionnelle ayant la valeur de résistance changeable comme variable commandée.

8. Procédé selon la revendication 7,
**caractérisé en ce**
**qu'**un régulateur PI est implémenté comme régulateur (40).

9. Procédé selon l'une quelconque des revendications 6 à 8,
**caractérisé en ce**
**qu'**une résistance de protection (Rs) pour chaque conducteur actif (L₁, L₂) est montée en série au circuit de résistance (12) ohmique respectif.
